# EUROPÄISCHE PATENTSCHRIFT

(11) **EP 0 306 091 B1**
(45) Veröffentlichungstag und Bekanntmachung des Hinweises auf die Patenterteilung: **15.12.1993**
(21) Anmeldenummer: 88201835.1
(22) Anmeldetag: 29.08.1988
(51) Int. Cl.: G03F 1/00

(54) **Verfahren zur Herstellung einer Maske für Strahlungslithographie**
Process for the production of a mask for radiation lithography
Procédé de fabrication d'un masque pour lithographie par rayonnement

(30) Priorität: 03.09.1987 DE 3729432
(43) Veröffentlichungstag der Anmeldung: 08.03.1989
(73) Patentinhaber: Philips Patentverwaltung GmbH, 22335 Hamburg (DE); Philips Electronics N.V., 5621 BA Eindhoven (NL)
(72) Erfinder: Bruns, Angelika, D-2359 Henstedt-Ulzburg (DE); Götze, Waldemar, D-2000 Hamburg 61 (DE); Harms, Margret, D-2000 Hamburg 61 (DE); Lüthje, Holger, Dipl.-Ing., D-2083 Halstenbek (DE)
(74) Vertreter: Kupfermann, Fritz-Joachim, Dipl.-Ing.

(56) Entgegenhaltungen:
- GB-A- 2 009 442
- JP-A- 6 240 726
- PATENT ABSTRACTS OF JAPAN, Band 9, Nr. 157 (P-369)[1880], 2. Juli 1985 & JP-A-60 33 555 (KONISHIROKU SHASHIN KOGYO K.K.) 20-02-1985
- IEEE TECHNICAL DIGEST INTERNATIONAL ELECTRON DEVICES MEETING, Washington, DC, 1.-3. Dezember 1975, Seiten 17-19, IEEE, New York, US.
- PATENT ABSTRACTS OF JAPAN, Band 9, Nr. 195 (P-379)[1918], 13. August 1985 & JP-A-60 61 750 (NIPPON DENKI K.K.) 09-04-1985
- JOURNAL OF VACUUM SCIENCE AND TECHNOLOGY, Teil B, Band 5, Nr. 1, Januar-Februar 1987, Seiten 283-287, American Vacuum Society, Woodbury, NY, US; M. KARNEZOS et al.: "Tungsten: An alternative to gold for X-ray masks"
- JOURNAL OF VACUUM SCIENCE AND TECHNOLOGY, Teil B, Band 4, Nr. 1, Januar/Februar 1986, Seiten 221-225, "Second Series", New York, NY, US; K. SUZUKI et al.: "High flatness mask for step and repeat X-ray lithography"
- JAPANESE JOURNAL OF APPLIED PHYSICS, Band 17, Nr. 9, September 1978, Seiten 1693-1694, Tokyo, JP; H. YOSHIHARA et al.: "Preparation of Si-C films by plasma deposition process with neutralization"
- SOLID STATE TECHNOLOGY, Band 19, Nr. 9, September 1976, Seiten 55-58, Washington, US; E. BASSOUS et al.: "High transmission X-ray masks for lithographic applications"
- CHEMICAL ABSTRACTS, Band 93, Nr. 4, August 1980, Seite 880, Zusammenfassung Nr. 85139V, Columbus, Ohio, US & SU-A-715 362 (G.P. SERGIENKO et al.) 15-02-1980
- MICROELECTRONIC ENGINEERING, Band 6, Nr. 1-4+Index, Dezember 1987, Seiten 259-264, Elsevier Science Publishers B.V., Amsterdam, NL; H. LUETHJE et al.: "Improved Tungsten Absorber Technology for sub-half-micron X-ray Lithography"

## Beschreibung

Die Erfindung betrifft ein Verfahren zur Herstellung einer Absorberschicht für eine Maske für Strahlungslithographie mit einem Maskenträger und einem Substrat, auf dem die entsprechend dem gewünschten Maskenmuster zu strukturierende Absorberschicht aus teilweise oxidiertem Wolfram abgeschieden wird,
Die JP-A-62 40 726 (= US-A-4 719 161) beschreibt einen bekannten anderen Herstellungsprozeß für eine Compound-Schicht, der auf ein Spin-Coating Verfahren unter Zugrundelegung einer Peroxopoly Wolfram enthaltenden Flüssigkeit basiert. Abgesehen davon, daß die mit diesem bekannten Verfahren erzeugten Absorberstrukturen sehr rauhe Strukturkanten besitzen und schon deshalb nicht die erforderliche Qualität und Auflösung erzielt werden kann, die für Röntgenmasken mit Submikrometerstrukturen erforderlich ist, sind dieser Schrift keine Aussagen zur Situation der Lagegenauigkeit der Muster zu entnehmen, die wiederum in essentieller Weise vom Streß der Absorberschicht abhängig sind. Darüber hinaus ist der Schrift zu entnehmen, daß es sich bei dem Material um WO₃ bzw. WO₂ handelt, also Material mit bekannten und bestimmten anderen als anmeldungsgemäßen Eigenschaften. Ferner wurden diese bekannten Schichten direkt mittels Elektronenstrahlen strukturiert. Genau diese Empfindlichkeit gegenüber energetischen Strahlen (Elektronen- und Röntgenstrahlen sind hier in erster Näherung vergleichbar) sollte jedoch vermieden werden, weshalb eine Langzeitstabilität wünschenswert ist.

In JP-A-60-33555 (Abstract) wird eine Schicht als Ätzmaskierung in einem Trockenätzprozeß beschrieben. Hierbei stehen grundsätzlich andere als anmeldungsgemäße Eigenschaften im Vordergrund. Insofern enthält diese Schrift auch keine Angaben über Streß und Stabilität, die jedoch für Röntgenmasken von essentieller Bedeutung sind. Ferner handelt es sich bei dieser Schicht um ein anderes Material, was bereits aus der Angabe zu ersehen ist, daß die Schicht für optische Strahlung (436 nm) noch teildurchlässig ist.

Aus Solid State Technology, 1972, Juli, Seiten 21 bis 25 ist es bekannt, bei photolithographischen Prozessen, mit denen z.B. Halbleitersysteme mit Strukturabmessungen im Mikrometerbereich hergestellt werden, die Belichtung von Photolack mit Röntgenstrahlen vorzunehmen. Die Leistungsfähigkeit der Lithographie ist erkennbar an der minimalen Streifenbreite der Strukturen, die mit ihr zu erreichen ist: Lichtlithographie ≈ 2 bis 0,8 µm, Elektronenstrahllithographie, Röntgenstrahllithographie und Ionenstrahllithographie ≈ 0,5 µm und kleiner.

Die Benutzung von z.B. Röntgenstrahlen zur Belichtung eines zu strukturierenden Lacks bringt den Vorteil, daß störende Beugungserscheinungen bei der Projektion der maskierenden Strukturen auf die Lackschicht herabgesetzt werden. Für die Belichtung mit Röntgenstrahlen sind spezielle Bestrahlungsmasken für die Strukturerzeugung im Lack erforderlich. Das gleiche gilt für die Belichtung mit Ionenstrahlen. Da die Anwendung der Röntgenstrahllithographie im Submikrometerbereich angesiedelt ist, müssen Lagegenauigkeit und laterale Abmessungen der Absorbermuster höchst präzise sein.

Hinsichtlich der Lagegenauigkeit ist neben den mechanischen Eigenschaften des Substrates, auf dem die Absorberschicht angebracht ist, insbesondere die Spannung in der relativ dicken (0,2 bis 1,2 µm) Absorberschicht von Bedeutung. Diese Spannungen wirken sich besonders aus, wenn als Substrat nicht relativ dicke Einkristallscheiben, z.B. Siliciumscheiben, die mit Dicken in der Größenordnung von 0,5 mm eingesetzt werden, verwendet werden, sondern wenn als Substrate Membranen mit Dicken im Bereich von 1 bis 4 µm verwendet werden. Spannungen in der Absorberschicht sollten < 10⁷N/m² sein und diese Eigenspannungen dürfen sich auch nicht bei Bestrahlung mit Lithographiestrahlung oder über eine längere Lagerungsdauer der Masken verändern.

Es sind die unterschiedlichsten Versuche gemacht worden, Absorberstrukturen spannungsarm auszubilden. Es sind sogenannte additive Verfahren bekannt, bei denen das Negativ des gewünschten Maskenmusters in einer dickeren Lackschicht erzeugt und die Fensterbereiche mit Hilfe galvanischer Abscheidung von Gold aufgefüllt werden. Ein auf diese Weise hergestellter Gold-Absorber zeichnet sich durch eine hohe Maßhaltigkeit und eine geringe Eigenspannung aus. Von Nachteil sind jedoch die hohe thermische Ausdehnung von Gold, die geringe Alterungsstabilität und die erhebliche Fehlerquote (unzureichende Gold-Plattierung) im Falle der Herstellung von sehr feinen Maskenmustern.

Als Alternative hierzu ist die Erzeugung von Absorberstrukturen mittels reaktiv ätzbarer Absorberschichten bekannt.
Ein solches Verfahren ist z.B. aus DE-OS 31 19 682 bekannt, bei dem relativ spannungsarme Masken für Röntgenstrahl- oder Ionenstrahllithographie erhalten werden durch reaktives Ätzen einer Molybdänschicht, die auf einer für die Lithographiestrahlung transparenten, auf einem Bor-dotierten Silicium-Maskenträger angebrachten Membran abgeschieden wurde.

Diese Masken sind relativ spannungsarm, zeigen jedoch noch Restspannungen, die für gewisse Anwendungszwecke nicht wünschenswert sind.

Der Erfindung liegt die Aufgabe zugrunde, ein Verfahren zur Herstellung von Masken für Lithographiestrahlung zu schaffen, mit dem Maskenstrukturen hergestellt werden können, die in der Absorberschicht nur noch eine minimale Restspannung in einem definierten Bereich aufweisen und mit dem diese Restspannung reproduzierbar einstellbar ist.

Diese Aufgabe wird erfindungsgemäß dadurch gelöst, daß während des Abscheidens der Absorberschicht Sauerstoff in bestimmter Menge zugesetzt wird, wodurch die auf dem Substrat abgeschiedene Absorberschicht einen geringen, vorbestimmbaren Streß und einen Sauerstoffgehalt im Bereich von 21 bis 29 at% aufweist.

Nach vorteilhaften Weiterbildungen des Verfahrens nach der Erfindung wird die Absorberschicht mit einem Sauerstoffgehalt im Bereich von 23 bis 28 Atom%, vorzugsweise im Bereich von 26 bis 27 Atom% ausgebildet. Die Dicke der Absorberschicht ist in Abhängigkeit von der angewandten Lithographiestrahlung zu wählen.

Nach vorteilhaften Weiterbildungen des Verfahrens nach der Erfindung wird die Absorberschicht mittels Kathodenzerstäubung abgeschieden und zwar in Schichtdicken im Bereich von 0,2 bis 1,2 µm.

Nach weiteren vorteilhaften Ausbildungen des Verfahrens nach der Erfindung wird vor Anbringen der Absorberschicht zunächst eine für die Lithographiestrahlung transparente Zwischenschicht auf dem Substrat angebracht, wobei die Zwischenschicht eine Si0₂-Schicht, eine Si₃N₄-Schicht, eine Ti0₂-Schicht und/oder eine Ti-Schicht sein kann, deren Dicke im Bereich von 10 bis 100 nm liegt.

Derartige Zwischenschichten haben den Vorteil, daß sie als Diffusionssperre wirken und damit das Schichtwachstum der Absorberschicht optimieren können.

Nach vorteilhaften Weiterbildungen des Verfahrens nach der Erfindung werden als Substrate für die Absorberschicht entweder Scheiben einer Dicke von einigen Zehntel mm aus einkristallinem Silicium oder aus Siliciumcarbid eingesetzt oder es werden dünne Membranen einer Dicke im Bereich von 1 bis 4 µm aus Silicium, Siliciumcarbid, Bornitrid oder Siliciumnitrid als Substrate eingesetzt.

Für die Ausbildung einer extrem spannungsarmen Absorberschicht aus Wolfram ist der Sauerstoffgehalt in der Schicht maßgebend. Sauerstoff wird vorzugsweise während der Herstellung der Absorberschicht mittels eines Kathodenzerstäubungsprozesses in die Schicht eingebaut und kann nach einer vorteilhaften Weiterbildung des erfindungsgemäßen Verfahrens in einem anschließenden Temperprozeß bei einer Temperatur von etwa 200 °C in vorzugsweise oxidierender Atmosphäre auf einen gewünschten Wert eingestellt werden. Der gewünschte Sauerstoffgehalt in der Schicht wird über während des Temperprozesses durchgeführte Spannungsmessungen an den mit der Absorberschicht versehenen Substraten kontrolliert. Ist bereits während des Abscheidungsprozesses der Absorberschicht eine ausreichende Sauerstoffmenge in die Schicht eingebaut, trägt der Temperprozeß, der dann in neutraler Atmosphäre durchgeführt wird, zur Stabilisierung der Teiloxidation des abgeschiedenen Absorbermaterials bei.
Werden als Substrate für die Absorberschichten dünne Membranen eingesetzt, kann sich ein Temperprozeß erübrigen, da diese dünnen Substrate sich schon während des Kathodenzerstäubungsprozesses ausreichend aufheizen und eine Temperung gleichzeitig mit der Abscheidung der Absorberschicht einhergeht. Dickere Substrate, wie z.B. Silicium-Einkristallscheiben, heizen sich beim Abscheidungsprozeß der Absorberschicht mittels eines Kathodenzerstäubungsprozesses weniger auf, hier ist ein anschließender Temperprozeß in der Regel von Vorteil.

Die mit der Erfindung erzielten Vorteile bestehen insbesondere darin, daß extrem spannungsarme Absorberschichten hergestellt werden können, deren minimale Restspannung auf einen gewünschten Wert über den in die Absorberschicht eingebauten Sauerstoffanteil eingestellt werden kann.

Die nach dem vorliegenden Verfahren eingestellten Restspannungen in den Absorberschichten sind < 10⁷N/m². Schichten, die mit einem Sauerstoffgehalt von etwa 26,5 ± 0,5 Atom% in der Schicht hergestellt wurden, zeigten auch nach einer Lagerung über eine Dauer von vielen Monaten sowie nach Synchrotronbestahlung stabile Spannungswerte < 10⁷N/m².
Ein weiterer Vorteil des vorliegenden Verfahrens ist, daß auch Substrate mit einer Absorberschicht versehen werden können, die, z.B. in Form einer dünnen Membran, auf Glasträger aufgeklebt sind; derartige Verbundsubstrate sind thermisch häufig nur begrenzt belastbar (bis zu Temperaturen ≦ 200°C).

Ein Vorteil der mit dem vorliegenden Verfahren hergestellten Absorberschichten ist, daß sie besonders gut an Silicium- oder an Siliciumcarbid-Substraten haften.

Ein weiterer Vorteil der mit dem vorliegenden Verfahren hergestellten Absorberschichten ist ihre hervorragende reaktive Ätzbarkeit in Fluor-haltigen Gasen zur Herstellung gewünschter Absorberstrukturen und ihre ausgezeichnete Absorption von Röntgenstrahlen.

Ein weiterer Vorteil des mit dem vorliegenden Verfahren dargestellten Absorbermaterials in Form von teilweise oxidiertem Wolfram ist, daß es bei der Herstellung von Halbleiterbauelementen mit MOS-Charakteristik (metal on silicon) gut angewendet werden kann; es ergeben sich keine Kontaminationsprobleme wie z.B. bei Absorberstrukturen aus Gold.

Anhand der Zeichnung werden Ausführungsbeispiele der Erfindung beschrieben und in ihrer Wirkungsweise erläutert. Es zeigen:
- Fig. 1: Einfluß des Sauerstoffgehaltes in nach dem erfindungsgemäßen Verfahren hergestellten Wolfram-Schichten auf deren Spannung,
- Fig. 2: Einfluß eines Temperprozesses in oxidierender Atmosphäre auf die Spannung in nach dem erfindungsgemäßen Verfahren hergestellten oxidierten Wolfram-Schichten,
- Fig. 3: Einfluß einer an das Substrat während des Abscheideprozesses der Absorberschicht mittels Kathodenzerstäubung angelegten elektrischen Vorspannung auf den Sauerstoffeinbau in der Schicht.

Als Ausführungsbeispiel wird die Herstellung einer teiloxidierten Wolfram-Absorberschicht mittels Kathodenzerstäubung beschrieben.

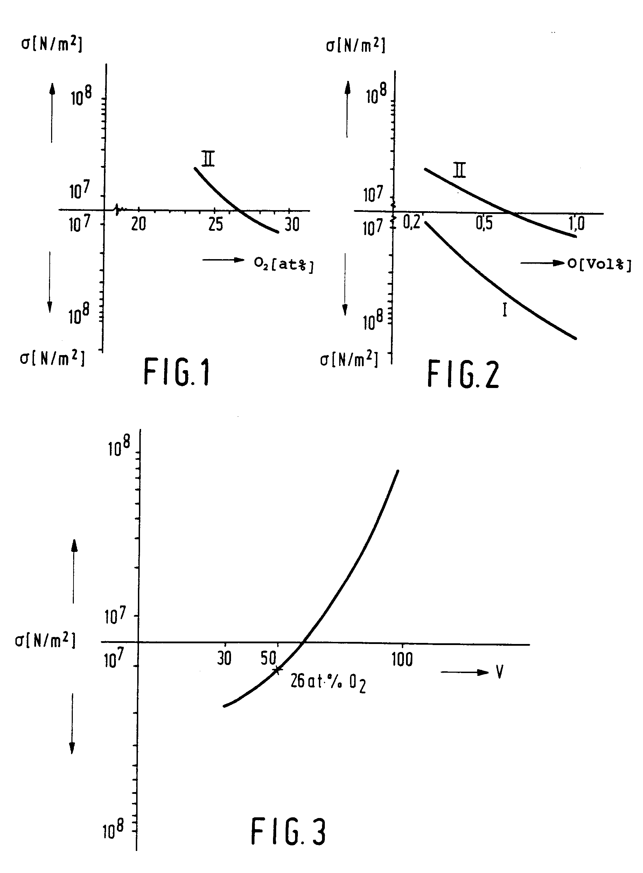

In eine HF-Kathodenzerstäubungsanlage werden ein Wolfram-Target und auf einem wassergekühlten Substrathalter ein Substrat in Form einer einkristallinen Silicium-Scheibe in einem Abstand von 40 mm zueinander eingebracht. Danach wird die Kathodenzerstäubungsanlage bis auf einem Restgasdruck von < 6,65.10⁻⁴ Pa evakuiert. Der Kathodenzerstäubungsprozeß wird unter einer Inertgasatmosphäre, vorzugsweise Argon, eines Drucks von ≈ 4 Pa, dem ein Sauerstoff-Anteil von ≈ 0,6% zugeführt ist, bei einer Leistungsdichte von 0,8 W/cm² durchgeführt. Es werden Schichten einer Dicke von 0,8 µm abgeschieden. Eine auf diese Weise hergestellte Schicht besitzt eine Druckspannung von > 5.10⁷ Pa. Durch einen nachfolgenden Temperprozeß bei einer Temperatur von ≈ 200 °C über eine Dauer von ≈ 5 h in einer sauerstoffhaltigen Atmosphäre wird der Sauerstoffanteil der Schicht auf einen Wert von etwa 26,5 Atom% eingestellt, wodurch sich die Spannung in der Absorberschicht auf einen Wert < 10⁷N/m² verringert. Hierzu wird verwiesen auf die Figuren 1 und 2, wobei die Kurve I die Spannung in einer ungetemperten Schicht und die Kurven II die Spannung in bei 200 °C in sauerstoffhaltiger Atmosphäre getemperten Schichten zeigen. Der Temperprozeß kann entweder in der zur Abscheidung der Absorberschicht eingesetzten HF-Kathodenzerstäubungsanlage oder auch extern durchgeführt werden.

Der zur Verringerung der Spannung in der Absorberschicht erforderliche Sauerstoff kann auch auf andere, dem Fachmann geläufige, Weise in die Absorberschicht eingebaut werden.

So kann der Prozeß, wie oben beschrieben, ausgeführt werden unter Anwendung eines Wₓ0ₓ-Targets in Argonatmosphäre.

Der Prozeß kann auch unter Anwendung eines Wₓ0_{y}-Targets oder eines W-Targets, jedoch mit einem höheren Anteil als 0,6% an Sauerstoff in der Gasatmosphäre ausgeführt werden; die Paramater des sich an den Abscheidungsprozeß anschließenden Temperprozesses sind dann entsprechend den während des Temperprozesses gemessenen Spannungswerten in der Absorberschicht jeweils einzustellen.

Es kann auch so vorgegangen werden, daß der Kathodenzerstäubungsprozeß zur Abscheidung der Absorberschicht mit einer höheren Leistungsdichte als 0,8 W/cm² durchgeführt wird, wobei die Mengen des Prozeßgases aus z.B. Argon und Sauerstoff entsprechend dem gewünschten Sauerstoffeinbau in die Schicht eingestellt werden. Werden bei dieser Art Verfahrensführung z.B. dünne Substrate, also Membranen, eingesetzt, kann ein nachfolgender Temperprozeß gespart werden, weil sich dünne Substrate bei einem Kathodenzerstäubungsprozeß mit höherer Leistungsdichte von selbst ausreichend hoch erwärmen.

Es kann auch so vorgegangen werden, daß der Kathodenzerstäubungsprozeß mit einer an das Substrat angelegten Gleich- oder hochfrequenten Wechselspannung zur gezielten Steuerung des Sauerstoffeinbaus in die Schicht durchgeführt wird. Geeignete Prozeßparameter hierbei sind 60 V Gleich- oder hochfrequente Wechselspannung, Prozeßgas Argon mit 0,1% Sauerstoff, Prozeßgasdruck ≈ 4 Pa. Nach einem Temperprozeß bei einer Temperatur von ≈ 200 °C über eine Dauer von ≈ 15 h in sauerstoffhaltiger Atmosphäre liegt ein Sauerstoffanteil von 26 Atom% in der Schicht vor (vergleiche Figur 3).

Der gewünschte Sauerstoffeinbau in die Absorberschicht kann z.B. auch über eine Implantation von Sauerstoffionen erfolgen.

Als vorteilhaft haben sich Zwischenschichten als Diffusionssperre zwischen dem Substrat und der Absorberschicht erwiesen. Im Rahmen des vorliegenden Verfahrens wurden mittels HF-Kathodenzerstäubung bei einer Leistungsdichte von 0,8 W/cm² unterschiedliche Schichten einer Dicke von etwa 10 nm wie folgt angebracht:
1. Si0₂-Schicht mittels eines Si0₂-Targets unter Argon-Atmosphäre eines Drucks von ≈ 2,7 Pa;
2. Si₃N₄-Schicht mittels eines Si-Targets unter Argon/Stickstoff-Atmosphäre (Argon-Druck ≈ 0,8 Pa, Stickstoffdruck ≈ 0,5 Pa);
3. Ti0₂-Schicht mittels eines Ti-Targets unter Argon/Sauerstoff-Atmosphäre (Argon-Druck ≈ 0,8 Pa, Sauerstoff-Druck ≈ 1,6 Pa);
4. Ti-Schicht mittels eines Ti-Targets unter Argon-Atmosphäre eines Drucks von ≈ 0,8 Pa.

Vorteilhaft ist es, zur Kompensation von in der Absorberschicht vorhandenen Restspannungen auf der Absorberschicht z.B. einer Dicke von 0,8 µm eine für die eingesetzte Lithographiestrahlung transparente Deckschicht, z.B. eine Nitridschicht, in einer Dicke von 0,2 µm mittels Kathodenzerstäubung anzubringen. Hierfür werden als Prozeßgas Stickstoff und Argon eingesetzt (Argon-Druck ≈ 0,8 Pa, Stickstoff-Druck ≈ 0,5 Pa) und die Schicht wird bei einer Leistungsdichte von 0,8 W/cm² abgeschieden.

## Patentansprüche

1. Verfahren zur Herstellung einer Absorberschicht für eine Maske für Strahlungslithographie mit einem Maskenträger und einem Substrat, auf dem die entsprechend dem gewünschten Maskenmuster zu strukturierende Absorberschicht aus teilweise oxidiertem Wolfram abgeschieden wird,
dadurch gekennzeichnet, daß während des Abscheidens der Absorberschicht Sauerstoff in bestimmter Menge zugesetzt wird, wodurch die auf dem Substrat abgeschiedene Absorberschicht einen geringen, vorbestimmbaren Streß und einen Sauerstoffgehalt im Bereich von 21 bis 29 at% aufweist.

2. Verfahren nach Anspruch 1,
dadurch gekennzeichnet,
daß die Absorberschicht mit einem Sauerstoffgehalt im Bereich von 23 bis 28 Atom% ausgebildet wird.

3. Verfahren nach Anspruch 1,
dadurch gekennzeichnet,
daß die Absorberschicht mit einem Sauerstoffgehalt im Bereich von 26 bis 27 Atom% ausgebildet wird.

4. Verfahren nach mindestens einem der Ansprüche 1 bis 3,
dadurch gekennzeichnet,
daß die Absorberschicht mit einer Dicke im Bereich von 0,2 bis 1,2 µm abgeschieden wird.

5. Verfahren nach mindestens einem der Ansprüche 1 bis 4,
dadurch gekennzeichnet,
daß die Absorberschicht mittels Kathodenzerstäubung abgeschieden wird.

6. Verfahren nach mindestens einem der Ansprüche 1 bis 5,
dadurch gekennzeichnet,
daß vor Anbringen der Absorberschicht zunächst eine für die Lithographiestrahlung transparente Zwischenschicht auf dem Substrat angebracht wird.

7. Verfahren nach Anspruch 6,
dadurch gekennzeichnet,
daß eine Zwischenschicht aus mindestens einem der Werkstoffe Si0₂, S₃N₄, Ti0₂ oder Ti angebracht wird.

8. Verfahren nach mindestens einem der Ansprüche 1 bis 7,
dadurch gekennzeichnet,
daß als Substrat eine einkristalline Silicium-Scheibe einer Dicke im Bereich von einigen Zehntel mm oder eine Silicium-Membran einer Dicke im Bereich von 1 bis 4 µm eingesetzt wird.

9. Verfahren nach mindestens einem der Ansprüche 1 bis 7,
dadurch gekennzeichnet,
daß als Substrat eine Siliciumcarbid-Scheibe einer Dicke im Bereich von einigen Zehntel mm oder eine Siliciumcarbid-Membran einer Dicke im Bereich von 1 bis 4 µm eingesetzt wird.

10. Verfahren nach mindestens einem der Ansprüche 1 bis 7,
dadurch gekennzeichnet,
daß als Substrat eine Bornitrid-Membran einer Dicke im Bereich von 1 bis 4 µm eingesetzt wird.

11. Verfahren nach mindestens einem der Ansprüche 1 bis 7,
dadurch gekennzeichnet,
daß als Substrat eine Siliciumnitrid-Membran einer Dicke im Bereich von 1 bis 4 µm eingesetzt wird.

12. Verfahren nach mindestens einem der Ansprüche 1 bis 11,
dadurch gekennzeichnet,
daß die Absorberschicht einem Temperprozeß bei einer Temperatur im Bereich von etwa 100 bis 400 °C über eine Dauer von 1 bis 15 h unterzogen wird.

13. Verfahren nach Anspruch 12,
dadurch gekennzeichnet,
daß der Temperprozeß in einer oxidierenden Atmosphäre durchgeführt wird.

14. Verfahren nach mindestens einem der Ansprüche 1 bis 11,
dadurch gekennzeichnet,
daß an das Substrat während des Abscheideprozesses der Absorberschicht eine elektrische Vorspannung (Gleich- oder hochfrequente Wechselspannung) im Bereich von 30 bis 100 V angelegt wird.

15. Verfahren nach mindestens einem der Ansprüche 1 bis 14,
dadurch gekennzeichnet,
daß zur Kompensierung von Restspannungen auf der Absorberschicht eine für die Lithographiestrahlung transparente Deckschicht einer Dicke im Bereich von 0,05 bis 0,7 µm angebracht wird.

16. Verfahren nach Anspruch 15,
dadurch gekennzeichnet,
daß als Deckschicht eine Nitridschicht angebracht wird.

## Claims

1. A method of manufacturing an absorber layer for a mask for radiation lithography having a mask support and a substrate on which an absorber layer, which is to be structured in accordance with the desired mask pattern, is deposited from partly oxydized tungsten, characterized in that a certain amount of oxygen is added during the deposition of the absorber layer, whereby the absorber layer deposited on the substrate is given a small, predeterminable stress and an oxygen content of 21 to 29 at.%.

2. A method as claimed in claim 1, characterized in that the absorber layer is formed with a oxygen content in the 23 to 28 at.% range.

3. A method as claimed in Claim 1, characterized in that the absorber layer is formed with an oxygen content in the 26 to 27 at.% range.

4. A method as claimed in at least one of Claims 1 to 3, characterized in that the absorber layer is deposited in a thickness in the 0.2 to 1.2 µm range.

5. A method as claimed in at least one of Claims 1 to 4, characterized in that the absorber layer is deposited by means of cathode sputtering.

6. A method as claimed in at least one of Claims 1 to 5, characterized in that, before the absorber layer is provided, first an intermediate layer transparent to the lithography radiation is formed on the substrate.

7. A method as claimed in Claim 6, characterized in that, an intermediate layer of at least one of the materials SiO₂, Si₃N₄, TiO₂ or Ti is provided.

8. A method as claimed in at least one of the Claims 1 to 7, characterized in that a monocrystalline silicon wafer having a thickness in the range of a few tenths of a millimetre or a silicon diaphragm having a thickness in the 1 to 4 µm range is used as the substrate.

9. A method as claimed in at least one of Claims 1 to 7, characterized in that a silicon carbide wafer having a thickness in the rage of a few tenths of a millimetre or a silicon carbide diaphragm having a thickness in the 1 to 4 µm range is used as the substrate.

10. A method as claimed in at least one of Claims 1 to 7, characterized in that as substrate a boron nitride diaphragm having a thickness in the 1 to 4 µm range is used as the substrate.

11. A method as claimed in at least one of Claims 1 to 7, characterized in that a silicon nitride diaphragm having a thickness of 1 to 4 µm is used as the substrate.

12. A method as claimed in at least one of Claims 1 to 11, characterized in that the absorber layer is subjected to a annealing process at a temperature of about 100 to 400° C for a period of 1 to 15 h.

13. A method as claimed in Claim 12, characterized in that the annealing process is carried out in a oxidizing atmosphere.

14. A method as claimed in at least one of Claims 1 to 11, characterized in that an electrical bias voltage (direct voltage or high-frequency alternating voltage) of 30 to 100 V is applied to the substrate during the process of depositing the absorber layer.

15. A method as claimed in at least one of Claims 1 to 14, characterized in that for compensation of residual stresses a covering layer transparent to the lithography radiation and having a thickness of 0.05 to 0.7 µm is provided on the absorber layer.

16. A method as claimed in Claim 15, characterized in that a nitride layer is provided as the covering layer.

## Revendications

1. Procédé de réalisation d'une couche absorbante pour un masque par lithographie par rayonnement muni d'un porte-masque et d'un substrat sur lequel est déposée la couche absorbante de tungstène partiellement oxydé devant être structurée suivant les motifs de masque voulus, caractérisé en ce qu'au cours du dépôt de la couche absorbante, on ajoute de l'oxygène dans une quantité déterminée de façon que la couche absorbante déposée sur le substrat présente une contrainte faible prédéterminée et une teneur en oxygène se situant dans la gamme comprise entre 21 et 29% en atomes.

2. Procédé selon la revendication 1, caractérisé en ce que la couche absorbante est réalisée à une teneur d'oxygène comprise entre 23 et 28% en atomes.

3. Procédé selon la revendication 1, caractérisé en ce que la couche absorbante est réalisée à une teneur d'oxygène comprise entre 26 et 27% en atomes.

4. Procédé selon au moins l'une des revendications 1 à 3, caractérisé en ce que la couche absorbante est formée par dépôt à une épaisseur comprise entre 0,2 et 1,2 µm.

5. Procédé selon au moins l'une des revendications 1 à 4, caractérisé en ce que la couche absorbante est formée par dépôt par pulvérisation cathodique.

6. Procédé selon au moins l'une des revendications 1 à 5, caractérisé en ce que, avant la formation de la couche absorbante, on forme d'abord, sur le substrat, une couche intermédiaire transparente au rayonnement de lithographie.

7. Procédé selon la revendication 6, caractérisé en ce qu'on forme une couche intermédiaire constituée par au moins l'un des matériaux SiO₂, Si₃N₄. TiO₂ et Ti.

8. Procédé selon au moins l'une des revendications 1 à 7, caractérisé en ce que, comme substrat, on utilise une lamelle de silicium monocristallin d'une épaisseur de l'ordre de quelques dixièmes de millimètres ou une membrane de silicium d'une épaisseur comprise entre 1 à 4 µm.

9. Procédé selon au moins l'une des revendications 1 à 7, caractérisé en ce que, comme substrat, on utilise une lamelle de carbure de silicium d'une épaisseur de l'ordre de quelques dixièmes de millimètre ou une membrane de carbure de silicium d'une épaisseur comprise entre 1 et 4 µm.

10. Procédé selon au moins l'une des revendications 1 à 7, caractérisé en ce que, comme substrat, on utilise une membrane de nitrure de bore comprise entre 1 et 4 µm.

11. Procédé selon au moins l'une des revendications 1 à 7, caractérisé en ce que, comme substrat, on utilise une membrane de nitrure de silicium d'une épaisseur comprise entre 1 et 4 µm.

12. Procédé selon au moins l'une des revendications 1 à 11, caractérisé en ce que la couche absorbante est soumise à une étape de recuit à une température comprise entre 100 et 400°C environ, pendant une durée comprise entre 1 et 15 h.

13. Procédé selon la revendication 12, caractérisé en ce que l'étape de recuit est effectuée dans une atmosphère oxydante.

14. Procédé selon au moins l'une des revendications 1 à 11, caractérisé en ce que, pendant l'étape de dépôt de la couche absorbante, il est appliqué au substrat une tension électrique de polarisation (tension continue ou tension alternative à haute fréquence) comprise entre 30 et 100 V.

15. Procédé selon au moins l'une des revendications 1 à 14, caractérisé en ce que, pour compenser des contraintes résiduelles, on forme sur la couche absorbante une couche de recouvrement transparente au rayonnement de lithographie et d'une épaisseur comprise entre 0,05 et 0,07 µm.

16. Procédé selon la revendication 15, caractérisé en ce que, comme couche de recouvrement, on forme une couche de nitrure.
